# EUROPÄISCHE PATENTSCHRIFT

(11) **EP 3 853 915 B1**
(45) Veröffentlichungstag und Bekanntmachung des Hinweises auf die Patenterteilung: **30.11.2022**
(21) Anmeldenummer: 19798269.7
(22) Anmeldetag: 04.11.2019
(51) Int. Cl.: H01L 41/053, H01L 41/047, H01L 41/113, H01L 41/23, H04R 17/02

(54) **ELEKTROMECHANISCHER WANDLER MIT EINEM SCHICHTAUFBAU**
ELECTROMECHANICAL TRANSDUCER WITH A LAYER STRUCTURE
CONVERTISSEUR ÉLECTROMÉCANIQUE À STRUCTURE STRATIFIÉE

(30) Priorität: 06.11.2018 DE 102018127651
(43) Veröffentlichungstag der Anmeldung: 28.07.2021
(73) Patentinhaber: iNDTact GmbH, 97076 Würzburg (DE)
(72) Erfinder: PETRICEVIC, Raino, 97074 Würzburg (DE)
(74) Vertreter: Dr. Gassner & Partner mbB
(86) Internationale Anmeldenummer: PCT/EP2019/080081
(87) Internationale Veröffentlichungsnummer: WO 2020/094559

(56) Entgegenhaltungen:
- CN-A- 104 881 193
- GB-A- 2 375 175
- US-A1- 2016 204 333
- RAJALA S ET AL: "Film-Type Sensor Materials PVDF and EMFi in Measurement of Cardiorespiratory Signals - A Review", IEEE SENSORS JOURNAL, Bd. 12, Nr. 3, März 2012 (2012-03), Seiten 439-446, XP011408119, ISSN: 1530-437X, DOI: 10.1109/JSEN.2010.2089510

## Beschreibung

Die Erfindung betrifft einen elektromechanischen Wandler mit einem Schichtaufbau.

In der EP 2 372 802 A2 wird ein elektromechanischer Wandler beschrieben, der mindestens eine untere Tragschicht, ein darauf angeordnetes elektrisches und/oder elektromechanisches Funktionselement umfasst, sowie eine Deckschicht, die elektrische Kontaktierung aufweist, die mit dem Funktionselement verbunden sind. CN 104881193 A offenbart einen elektromechanischer Wandler gemäß der Präambel des unabhängigen Anspruchs 1 sowie ein entsprechendes Verfahren zur Herstellung mit Schritten zum Bereitstellen und Assemblieren des elektromechanischen Funktionselements und der Schichten durch Verkleben.

Damit ein derartiger elektromechanischer Wandler kommerziell einsetzbar ist, wird ein effizientes Herstellungsverfahren benötigt. Der Erfindung liegt daher die Aufgabe zugrunde, einen elektromechanischen Wandler anzugeben, der für eine Produktion in einem industriellen Maßstab geeignet ist und robust und zuverlässig arbeitet. Daneben soll ein zugehöriges Herstellungsverfahren angegeben werden. Zur Lösung dieser Aufgabe ist ein elektromechanischer Wandler mit den Merkmalen des Anspruchs 1 vorgesehen.

Der erfindungsgemäße elektromechanische Wandler weist einen Schichtaufbau auf, der in dieser Reihenfolge Folgendes umfasst:
- eine erste Schicht, die in wenigstens einer Ebene wenigstens einen nach außen isolierten strukturiert elektrisch leitfähigen, als elektrische Abschirmung wirkenden Bereich aufweist,
- eine zweite, als Klebeschicht dienende Schicht, die zumindest punktuell elektrisch leitfähig ist,
- eine dritte, ein elektromechanisches Funktionselement aufweisende Schicht,
- eine vierte, als Klebeschicht dienende Schicht, die zumindest punktuell elektrisch leitfähig ist,
- eine fünfte Schicht, die in wenigstens einer Ebene wenigstens einen nach außen isolierten, strukturierten, elektrisch leitfähigen, als elektrische Abschirmung wirkenden Bereich aufweist, wobei die erste Schicht und/oder die fünfte Schicht eine an ihrer Außenseite freiliegende elektrische Kontaktierung aufweist bzw. aufweisen.

Der erfindungsgemäße elektromechanische Wandler zeichnet sich dadurch aus, dass er durch seinen Schichtaufbau einfach und kostengünstig in großen Stückzahlen hergestellt werden kann. Die äußeren Schichten, d. h. die erste Schicht und die fünfte Schicht, dienen insbesondere der Abschirmung des elektromechanischen Funktionselements, sodass dieses nicht durch äußere Einflüsse wie elektromagnetische Felder gestört werden kann. Ein weiterer Vorteil ist darin zu sehen, dass der erfindungsgemäße elektromechanische Wandler durch den Schichtaufbau vergleichsweise einfach herstellbar ist. Insbesondere können mehrere elektromechanische Wandler durch Aufeinanderlegen der einzelnen Schichten in einem einzigen Verfahren hergestellt werden, indem der Schichtaufbau (Nutzen) anschließend zerteilt wird, wodurch die einzelnen Wandler erhalten werden.

Bei dem erfindungsgemäßen elektromechanischen Wandler dienen die zweite Schicht und die vierte Schicht als Klebeschicht, die auf diese Weise die beiden benachbarten Schichten, d. h. die erste Schicht und die dritte Schicht bzw. die dritte Schicht und die fünfte Schicht miteinander verbinden. Wesentlich ist dabei, dass sowohl die zweite Schicht als auch die vierte Schicht zumindest punktuell elektrisch leitfähig sind. Auf diese Weise kann eine elektrische Verbindung über die verschiedenen Schichten hinweg erzielt werden.

Im Rahmen der Erfindung ist vorgesehen, dass die erste Schicht und/oder die fünfte Schicht eine an ihrer Außenseite freiliegende elektrische Kontaktierung aufweist bzw. aufweisen. Die Kontaktierung kann zum Anschließen eines elektrischen Verbindungselements, zum Beispiel einer Leitung, dienen. Es liegt auch im Rahmen der Erfindung, dass die Kontaktierung als Stecker oder als Buchse oder als elektronische Baueinheit ausgebildet ist. Wenn die Kontaktierung in dem elektromechanischen Wandler integriert ist, ist das elektrische Verbinden besonders einfach.

Die Kontaktierung kann zum Beispiel wie bei einer Speicherkarte, zum Beispiel einer SD-Karte, oder wie bei einer SIM-Karte für ein Mobiltelefon ausgebildet sein.

Mit besonderem Vorteil kann es bei dem erfindungsgemäßen elektromechanischen Wandler vorgesehen sein, dass jede Schicht wenigstens einen punktuellen elektrischen Kontakt oder eine Durchkontaktierung aufweist, über den oder über die die Schicht elektrisch leitend mit einer benachbarten Schicht verbunden ist. Auf diese Weise kann ein elektrisches Signal senkrecht zur Schichtebene zu einer oder zu beiden äußeren Schichten einfach oder mehrfach (redundant) übertragen werden.

Vorzugsweise besitzt bei dem erfindungsgemäßen elektromechanischen Wandler die zweite bis fünfte Schicht direkt oder indirekt über eine dazwischen angeordnete Schicht zumindest eine elektrisch leitfähige Verbindung zur ersten Schicht. Somit kann die vorzugsweise auf der ersten Schicht angeordneter Kontaktierung mit jeder einzelnen Schicht elektrisch verbunden sein, sofern dies für die Weiterleitung eines Signals oder aus anderen Gründen erforderlich ist.

Ein besonders robuster Aufbau des elektromechanischen Wandlers ergibt sich, wenn zwei benachbarte Schichten, vorzugsweise alle benachbarten Schichten, stoffschlüssig miteinander verbunden sind. Das bedeutet, dass alle Schichten fest miteinander verbunden sind, wodurch sich ein stabiler Aufbau des elektromechanischen Wandlers ergibt.

In weiterer Ausgestaltung der Erfindung kann es vorgesehen sein, dass wenigstens zwei benachbarte Schichten, vorzugsweise alle benachbarten Schichten, durch eine Polymermatrix, zum Beispiel einer Harzmatrix, stoffschlüssig und oder formschlüssig miteinander verbunden sind. Insbesondere die als Klebeschicht dienenden zweiten und vierten Schichten können auch selbst aus einer Polymermatrix bestehen oder einer Harzmatrix aufweisen. Alternativ können sie eine Klebefolie, eine thermoplastische Folie oder einen flüssigen oder viskosen Klebstoff aufweisen. In diesem Zusammenhang kann es vorgesehen sein, dass die stoffschlüssige Verbindung eine Polymeroberfläche mit einer Polymeroberfläche verbindet. Es kann jedoch auch vorgesehen sein, dass die stoffschlüssige Verbindung eine Metalloberfläche mit einer Metalloberfläche verbindet oder dass die stoffschlüssige Verbindung eine Polymeroberfläche mit einer Metalloberfläche verbindet. Vorzugsweise ist die stoffschlüssige Verbindung auf wenigstens 20 % der Fläche des elektromechanischen Wandlers aus Polymeren ausgebildet, insbesondere aus einer Harzmatrix. Alternativ kann die stoffschlüssige Verbindung durch einer Harzmatrix oder einen polymerbasierten Klebstoff erfolgen. Der Klebstoff kann durch Erwärmen, gegebenenfalls unter Druckbeaufschlagung, klebeaktiviert und/oder ausgehärtet werden.

Im Rahmen der Erfindung kann es vorgesehen sein, dass das Funktionselement als eines der folgenden Bauteile ausgebildet ist beziehungsweise dieses umfasst: piezoelektrischer Sensor, kapazitiver Sensor, induktiver Sensor, Leitfähigkeitssensor, resistiver Sensor, piezoresistiver Sensor, pyroelektrischer Sensor, Lagesensor, Gyrometer, Hall-Sensor, Magnetometer, Radarsensor, Näherungssensor. Jeder der genannten Sensoren kann für eine spezielle Messaufgabe eingesetzt werden. Mit den genannten Sensoren kann zum Beispiel Körperschall erfasst werden, d. h. Schwingungen eines Körpers oder eine Kraft, eine Dehnung oder eine Biegung. Aus diesen von den Sensoren erfassten Messwerten können weitere Größen abgeleitet oder errechnet werden. Beispielsweise können Körperschallschwingungen auch als Audiosignal erfasst werden.

Der erfindungsgemäße elektromechanische Wandler kann eine elektronische Schaltung mit einer oder mehreren der folgenden Komponenten aufweisen: Signalverstärker, Filter, A/D-Wandler, Steuergerät zur Signalverarbeitung, Datenspeicher, drahtloses Datenübertragungsmodul, Modul zur drahtlosen Übertragung von Energie, ASIC (application specific integrated circuit), DSP (digitaler Signalprozessor), FPGA (Field Programmable Gate Array).

Es liegt auch im Rahmen der Erfindung, dass der erfindungsgemäße elektromechanische Wandler mehrere aufeinander gestapelte gleiche oder unterschiedliche Schichten aufweist. Die Reihenfolge der Schichten kann verschieden sein. Beispielsweise können die gestapelten Schichten symmetrisch angeordnet sein. Wenigstens eine Schicht des erfindungsgemäßen elektromechanischen Wandlers kann ein faserverstärktes Polymer aufweisen. Derartige faserverstärktes Polymere lassen sich besonders gut zu einem Schichtaufbau zusammensetzen. Die Klebeschicht des erfindungsgemäßen elektromechanischen Wandlers kann zumindest abschnittsweise elektrisch isolierend sein. Eine elektrisch leitende Verbindung kann zum Beispiel durch ein elektrisch leitendes Polymer, das zum Beispiel Kohlenstofffasern oder Silberpartikel als Komponenten besitzt, gebildet sein. Die elektrische Leitfähigkeit kann dabei auch nur punktuell, senkrecht zur Schichtebene, vorhanden sein, während die Klebeschicht in der Ebene isoliert ist.

Im Rahmen der Erfindung ist es möglich, eine oder mehrere funktionelle Schichten direkt in dem elektromechanischen Wandler zu integrieren. Eine derartige Schicht kann ein elektronisches Bauteil, einen Sensor oder einen weiteren Sensor, zum Beispiel einen Temperatursensor, einen Lagesensor, einen Drehmomentsensor, einen Beschleunigungssensor oder eine oder mehrere der oben erwähnten elektronischen Schaltungen enthalten. Derartige Sensoren und Schaltungen lassen sich durch die Erfindung einfach und kostengünstig verbinden. Es ist auch möglich, eine vollständig mit elektronischen Bauteilen bestückte Leiterplatte in den erfindungsgemäßen Wandler zu integrieren.

Bei dem erfindungsgemäßen elektromechanischen Wandler kann wenigstens eine Schicht thermisch aushärtbar oder ausgehärtet oder selbstklebend sein. Ferner ist es möglich, dass der elektromechanische Wandler mehrere ein elektromechanisches Funktionselement aufweisende Schichten aufweist. Vorzugsweise weist wenigstens eine Schicht des elektromechanischen Wandlers ein faserverstärktes Polymer auf. Vorzugsweise ist die Klebeschicht zumindest abschnittsweise und/oder parallel zu einer durch die Klebeschicht definierten Ebene elektrisch isolierend ausgebildet.

Daneben betrifft die Erfindung ein Verfahren zur Herstellung eines elektromechanischen Wandlers, mit den folgenden Schritten:
- Bereitstellen einer ersten Schicht, die in wenigstens einer Ebene wenigstens einen nach außen isolierten, strukturierten, elektrisch leitfähigen, als elektrische Abschirmung wirkenden Bereich aufweist,
- Bereitstellen einer zweiten, als Klebeschicht dienenden Schicht, die zumindest punktuell elektrisch leitfähig ist,
- Bereitstellen einer dritten, ein elektromechanisches Funktionselement aufweisenden Schicht,
- Bereitstellen einer vierten, als Klebeschicht dienenden Schicht, die zumindest punktuell elektrisch leitfähig ist,
- Bereitstellen einer fünften Schicht, die in wenigstens einer Ebene wenigstens einen nach außen isolierten, strukturierten, elektrisch leitfähigen, als elektrische Abschirmung wirkenden Bereich aufweist.
- Stapeln und Ausrichten der ersten bis fünften Schicht zur Bildung eines Nutzens,
- Verpressen der Schichten unter Druck, und - Zerteilen des Nutzens.

Bei dem erfindungsgemäßen Verfahren kann es vorgesehen sein, dass die Schichten unter Wärmezufuhr miteinander verpresst werden. Insbesondere können die Schichten einige Minuten oder einige Sekunden oder vorzugsweise lediglich für Sekundenbruchteile miteinander verpresst werden.

Im Rahmen des Verfahrens kann es vorgesehen sein, dass wenigstens eine Schicht vor dem Verpressen einer Reinigung oder einer Oberflächenaktivierung unterzogen wird. Eine Oberflächenaktivierung kann in Form einer Plasmabehandlung erfolgen.

Bei dem erfindungsgemäßen Verfahren kann ein kalthärtender Klebstoff, ein thermoplastischer Heißschmelzkleber oder ein Duromer-Strukturkleber als Klebeschicht verwendet werden.

Weitere Vorteile und Einzelheiten der Erfindung werden nachfolgend anhand von Ausführungsbeispielen unter Bezugnahme auf die Zeichnungen erläutert. Die Zeichnungen sind schematische Darstellungen und zeigen:
- Fig. 1: eine geschnittene Ansicht eines ersten Ausführungsbeispiels eines erfindungsgemäßen elektromechanischen Wandlers,
- Fig. 2: ein zweites Ausführungsbeispiel eines erfindungsgemäßen elektromechanischen Wandlers, und
- Fig. 3: ein drittes Ausführungsbeispiel eines erfindungsgemäßen elektromechanischen Wandlers.

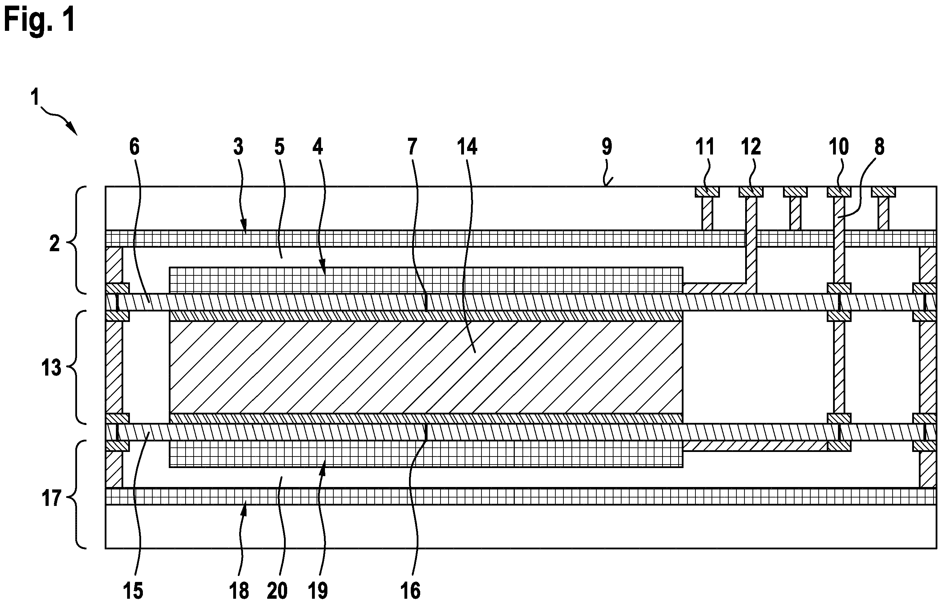

Fig. 1 ist eine geschnittene Ansicht und zeigt einen elektromechanischen Wandler 1 mit einem Schichtaufbau. Der elektromechanische Wandler 1 umfasst eine erste Schicht 2, die in wenigstens einer Ebene wenigstens einen nach außen isolierten, strukturierten, elektrisch leitfähigen, als elektrische Abschirmung wirkenden Bereich 3 aufweist. Der ebene Bereich 3 bildet eine äußere Schicht, die zur Außenseite des elektromechanischen Wandlers 1 elektrisch isoliert ist. Daneben umfasst die erste Schicht 2 einen weiteren ebenen Bereich 4, der von dem ebenen Bereich 3 beabstandet ist. Die beiden ebenen Bereiche 3, 4 sind in eine Polymermatrix 5 eingebettet und dadurch stoffschlüssig miteinander verbunden.

An die erste Schicht 2 schließt sich eine zweite Schicht 6 an, die als Klebeschicht dient. Die Klebeschicht ist an verschiedenen Punkten 7 elektrisch leitfähig. An diesen Punkten 7 ist jeweils eine elektrische Kontaktierung quer zur Klebeschicht, d. h. von einer Seite der Klebeschicht zur entgegengesetzten Seite, vorhanden. Von der als Klebeschicht dienenden zweiten Schicht 6 erstreckt sich senkrecht zur Schichtebene eine Kontaktierung 8 bis zur Außenseite 9 des elektromechanischen Wandlers 1. die Kontaktierung 8 mündet dort in einem Kontakt 10. In Fig. 1 erkennt man, dass an der Außenseite 9 weitere Kontakte vorhanden sind. Mehrere Kontakte 11 erstrecken sich bis zu dem ebenen Bereich 3. Ein Kontakt 12 verbindet die Außenseite 9 mit dem ebenen Bereich 4.

In der Ansicht von Fig. 1 befindet sich unterhalb der zweiten, als Klebeschicht dienenden Schicht 6 eine dritte, ein elektromechanisches Funktionselement aufweisende Schicht 13. In dem dargestellten Ausführungsbeispiel ist das elektromechanische Funktionselement als piezoelektrischer Sensor 14 ausgebildet. Der Sensor 14 macht von dem piezoelektrischen Effekt Gebrauch. Beim Einwirken eines mechanischen Drucks wird eine elektrische Ladung erzeugt, die einem Verstärker zugeführt werden kann. Anschließend kann das von dem piezoelektrischen Sensor 14 gelieferte Signal verarbeitet und ausgewertet werden.

Unterhalb der dritten Schicht 13 befindet sich in der Ansicht von Fig. 1 eine vierte, als Klebeschicht dienende Schicht 15, die wie die als Klebeschicht dienende Schicht 6 aufgebaut ist. Die als Klebeschicht dienende Schicht 15 ist punktuell elektrisch leitfähig. Dazu sind an mehreren Punkten 16 die Klebeschicht durchsetzende Kontaktierungen vorhanden. Die als Klebeschicht dienende Schicht 15 verbindet die dritte Schicht 13 und eine fünfte Schicht 17. Die fünfte Schicht 17 ist grundsätzlich wie die erste Schicht 2 aufgebaut. Sie umfasst in einer Ebene einen nach außen isolierten, strukturierten, elektrisch leitfähigen Bereich 18. Daneben umfasst die fünfte Schicht 17 einen weiteren ebenen Bereich 19, der von dem ebenen Bereich 18 in Dickenrichtung beabstandet ist. Die beiden ebenen Bereiche 18, 19 sind - analog zu den ebenen Bereichen 3, 4 der ersten Schicht 2 in eine Polymermatrix 20 eingebettet.

Von dem Kontakt 10 an der Außenseite 9 erstreckt sich die Kontaktierung 8 durch die zweite, als Klebeschicht dienende Schicht 6 und die vierte, als Klebeschicht dienende Schicht 15 bis zu der fünften Schicht 17, die auf diese Weise mit dem Kontakt 10 verbunden ist. Die verschiedenen Kontakte dienen zum elektrischen Kontaktieren des elektromechanischen Wandlers 1 mit externen Komponenten, beispielsweise mit einem Verstärker oder mit einer Auswerteschaltung.

Die insgesamt fünf Schichten des elektromechanischen Wandlers 1 bestehen aus einem Polymer oder einem faserverstärkten Polymer, wobei nach Bedarf elektrisch leitfähige oder elektrisch isolierende Bereiche in der Schicht vorgesehen sind. Jede Schicht weist wenigstens einen zumindest punktuell elektrisch leitenden Kontakt oder einen flächigen Kontakt oder eine Durchkontaktierung auf, über den die jeweilige Schicht mit einer oder mehreren benachbarten Schichten verbunden ist.

Der in diesem Ausführungsbeispiel beschriebene elektromechanische Wandler kann in einem automatisierten Verfahren in großen Stückzahlen einfach hergestellt werden. Dazu wird ein Nutzen hergestellt, der eine Vielzahl von in Reihen und Spalten angeordneter elektromechanischer Wandler umfasst. Nach dem Stapeln der einzelnen Schichten erfolgt das Verpressen unter Druck. Anschließend wird der Nutzen zerteilt, wodurch die einzelnen elektromechanischen Wandler entstehen.

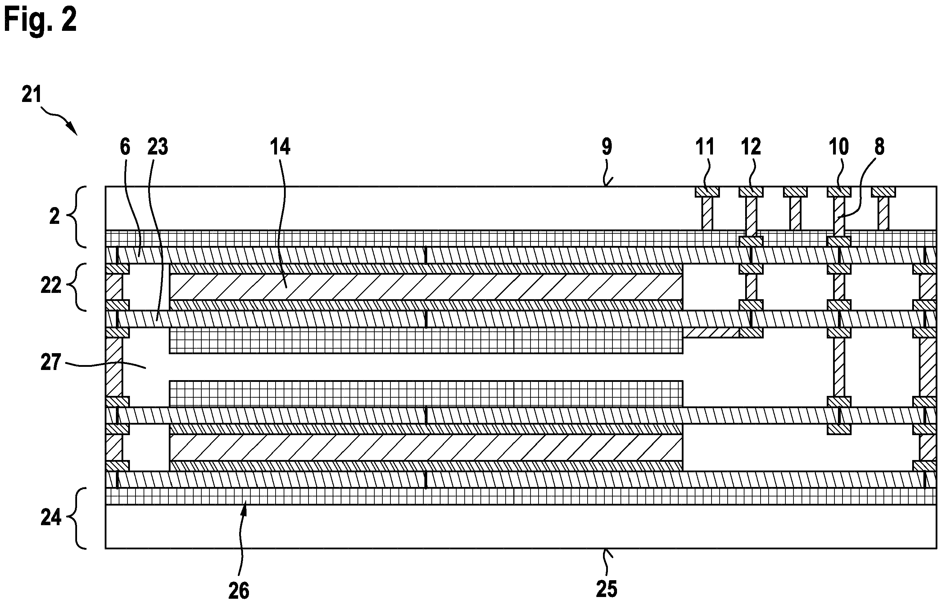

Fig. 2 zeigt ein zweites Ausführungsbeispiel eines elektromechanischen Wandlers 21, der ähnlich wie der in dem 1. Ausführungsbeispiel beschriebene Wandler aufgebaut ist. Auf eine detaillierte Beschreibung übereinstimmender Komponenten wird daher an dieser Stelle verzichtet.

Der elektromechanische Wandler 21 umfasst die erste Schicht 2 mit dem ebenen Bereich 3, der nach außen isoliert, strukturiert und elektrisch leitfähig ist und als elektrische Abschirmung dient. Daran schließt sich die als Klebeschicht dienende zweite Schicht 6 an. Eine dritte Schicht 22 umfasst ein elektromechanisches Funktionselement, das als Sensor 14 ausgebildet ist. Als Klebeschicht dient eine vierte Schicht 23, die sich in der Ansicht von Fig. 2 an der der Schicht 6 entgegengesetzten Seite der dritten Schicht 22 befindet.

Eine fünfte Schicht 24 bildet eine der Außenseite 9 gegenüberliegende Außenseite 25. Die fünfte Schicht 24 umfasst einen nach außen isolierten, strukturierten, elektrisch leitfähigen, als elektrische Abschirmung wirkenden Bereich 26. In Fig. 2 erkennt man, dass der elektromechanische Wandler 21 symmetrisch aufgebaut ist. Dementsprechend sind 2 identische Sensoren 14 vorhanden, die an beiden Seiten jeweils mit einer Klebeschicht versehen sind. An die Klebeschicht des in Fig. 2 unteren Sensors schließt sich die fünfte Schicht 24 an. Zwischen den beiden inneren Klebeschichten befindet sich eine Zwischenschicht 27.

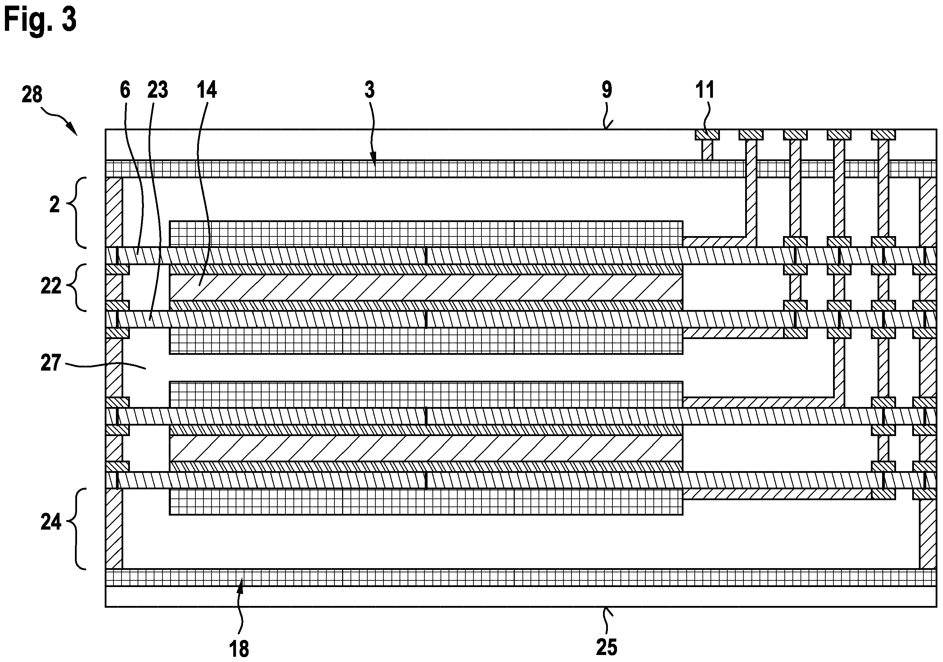

Fig. 3 zeigt ein weiteres Ausführungsbeispiel eines elektromechanischen Wandlers 28, der ähnlich wie der in Fig. 2 gezeigte elektromechanische Wandler aufgebaut ist und zusätzlich eine ähnliche Abschirmung wie das in Fig. 1 gezeigte Ausführungsbeispiel besitzt.

### Bezugszeichenliste

- 1: elektromechanischer Wandler
- 2: erste Schicht
- 3: ebener Bereich
- 4: ebener Bereich
- 5: Polymermatrix
- 6: zweite Schicht
- 7: Punkt
- 8: Kontaktierung
- 9: Außenseite
- 10: Kontakt
- 11: Kontakt
- 12: Kontakt
- 13: dritte Schicht
- 14: Sensor
- 15: vierte Schicht
- 16: Punkt
- 17: fünfte Schicht
- 18: ebener Bereich
- 19: ebener Bereich
- 20: Polymermatrix
- 21: elektromechanischer Wandler
- 22: dritte Schicht
- 23: vierte Schicht
- 24: fünfte Schicht
- 25: Außenseite
- 26: Bereich
- 27: Zwischenschicht
- 28: elektromechanischer Wandler

## Patentansprüche

1. Elektromechanischer Wandler (1, 21, 28) mit einem Schichtaufbau, umfassend in dieser Reihenfolge:
- eine erste Schicht (2), die in wenigstens einer Ebene wenigstens einen nach außen isolierten, strukturierten, elektrisch leitfähigen, als elektrische Abschirmung wirkenden Bereich (3) aufweist,
- eine zweite, als Klebeschicht dienende Schicht (6), die zumindest punktuell elektrisch leitfähig ist,
- eine dritte, ein elektromechanisches Funktionselement aufweisende Schicht (13, 22),
- eine vierte, als Klebeschicht dienende Schicht (15, 23), die zumindest punktuell elektrisch leitfähig ist,
- eine fünfte Schicht (17, 24), die in wenigstens einer Ebene wenigstens einen nach außen isolierten, strukturierten, elektrisch leitfähigen, als elektrische Abschirmung wirkenden Bereich (18) aufweist,
**dadurch gekennzeichnet, dass** die erste Schicht (2) und/oder die fünfte Schicht (17, 24) eine an ihrer Außenseite (9, 25) freiliegende elektrische Kontaktierung (8) aufweist bzw. aufweisen

2. Elektromechanischer Wandler nach Anspruch 1, **dadurch gekennzeichnet, dass** die elektrische Kontaktierung (8) als Stecker oder als Buchse oder als elektronische Baueinheit ausgebildet ist.

3. Elektromechanischer Wandler nach einem der vorangehenden Ansprüche, **dadurch gekennzeichnet, dass** jede Schicht (2, 5, 13, 15, 17, 22, 23, 24) wenigstens einen zumindest punktuell elektrisch leitfähigen Kontakt (10, 11, 12) oder eine Durchkontaktierung aufweist, über den oder über die die Schicht (2, 5, 13, 15, 17, 22, 23, 24) elektrisch leitend mit einer benachbarten Schicht (2, 5, 13, 15, 17, 22, 23, 24) verbunden ist.

4. Elektromechanischer Wandler nach einem der vorangehenden Ansprüche, **dadurch gekennzeichnet, dass** die zweite bis fünfte Schicht (6, 13, 15, 17, 22, 23, 24) direkt oder über eine dazwischen angeordnete Schicht zumindest eine elektrisch leitfähige Verbindung zur ersten Schicht (2) besitzt.

5. Elektromechanischer Wandler nach einem der vorangehenden Ansprüche, **dadurch gekennzeichnet, dass** zwei benachbarte Schichten (2, 5, 13, 15, 17, 22, 23, 24), vorzugsweise alle benachbarten Schichten (2, 5, 13, 15, 17, 22, 23, 24), stoffschlüssig miteinander verbunden sind.

6. Elektromechanischer Wandler nach Anspruch 5, **dadurch gekennzeichnet, dass** wenigstens zwei benachbarte Schichten (2, 5, 13, 15, 17, 22, 23, 24), vorzugsweise alle Schichten (2, 5, 13, 15, 17, 22, 23, 24), durch eine Polymermatrix (5) stoffschlüssig und/oder formschlüssig miteinander verbunden sind.

7. Elektromechanischer Wandler nach Anspruch 5 oder 6, **dadurch gekennzeichnet, dass** die stoffschlüssige Verbindung auf wenigstens 20 % der Fläche des elektromechanischen Wandlers (1, 21, 28) aus Polymeren, insbesondere aus einer Harzmatrix, ausgebildet ist.

8. Elektromechanischer Wandler nach einem der vorangehenden Ansprüche, **dadurch gekennzeichnet, dass** das Funktionselement als eines der folgenden Bauteile ausgebildet ist beziehungsweise dieses umfasst: piezoelektrischer Sensor (14), kapazitiver Sensor, induktiver Sensor, Leitfähigkeitssensor, resistiver Sensor, piezoresistiver Sensor, pyroelektrischer Sensor, Lagesensor, Gyrometer, Hall-Sensor, Magnetometer, Radarsensor, Näherungssensor, oder als elektronische Schaltung.

9. Elektromechanischer Wandler nach Anspruch 8, **dadurch gekennzeichnet, dass** die elektronische Schaltung eine oder mehrere der folgenden Komponenten aufweist: Signalverstärker, Filter, A/D-Wandler, Steuergerät zur Signalverarbeitung, Datenspeicher, drahtloses Datenübertragungsmodul, Modul zur drahtlosen Übertragung von Energie, ASIC (application specific integrated circuit), DSP (digitaler Signalprozessor), FPGA (Field Programmable Gate Array).

10. Elektromechanischer Wandler nach einem der vorangehenden Ansprüche, **dadurch gekennzeichnet, dass** wenigstens eine Schicht (2, 5, 13, 15, 17, 22, 23, 24) thermisch aushärtbar oder ausgehärtet oder selbstklebend ist.

11. Elektromechanischer Wandler nach einem der vorangehenden Ansprüche, **dadurch gekennzeichnet, dass** er mehrere ein elektromechanisches Funktionselement aufweisende Schichten aufweist.

12. Elektromechanischer Wandler nach einem der vorangehenden Ansprüche, **dadurch gekennzeichnet, dass** wenigstens eine Schicht (2, 5, 13, 15, 17, 22, 23, 24) ein faserverstärktes Polymer aufweist.

13. Elektromechanischer Wandler nach einem der vorangehenden Ansprüche, **dadurch gekennzeichnet, dass** die Klebeschicht zumindest abschnittsweise und/oder parallel zu einer durch die Klebeschicht definierten Ebene elektrisch isolierend ist.

14. Verfahren zur Herstellung eines elektromechanischen Wandlers (1, 21, 28), mit den folgenden Schritten:
- Bereitstellen einer ersten Schicht (2), die in wenigstens einer Ebene wenigstens einen nach außen isolierten, strukturierten, elektrisch leitfähigen, als elektrische Abschirmung wirkenden Bereich (3) aufweist,
- Bereitstellen einer zweiten, als Klebeschicht dienenden Schicht (6), die zumindest punktuell elektrisch leitfähig ist,
- Bereitstellen einer dritten, ein elektromechanisches Funktionselement aufweisenden Schicht (13, 22),
- Bereitstellen einer vierten, als Klebeschicht dienenden Schicht (15, 23), die zumindest punktuell elektrisch leitfähig ist,
- Bereitstellen einer fünften Schicht (17, 24), die in wenigstens einer Ebene wenigstens einen nach außen isolierten, strukturierten, elektrisch leitfähigen, als elektrische Abschirmung (18) wirkenden Bereich aufweist,
- Stapeln und Ausrichten der ersten bis fünften Schicht (2, 5, 13, 15, 17, 22, 23, 24) zur Bildung eines Nutzens,
- Verpressen der Schichten (2, 5, 13, 15, 17, 22, 23, 24) unter Druck, und - Zerteilen des Nutzens.

15. Verfahren nach Anspruch 14, wobei die Schichten (2, 5, 13, 15, 17, 22, 23, 24) unter Wärmezufuhr miteinander verpresst werden.

16. Verfahren nach Anspruch 14 oder 15, wobei die Schichten (2, 5, 13, 15, 17, 22, 23, 24) einige Minuten oder einige Sekunden oder vorzugsweise lediglich für Sekundenbruchteile miteinander verpresst werden.

17. Verfahren nach einem der Ansprüche 14 bis 16, wobei wenigstens eine Schicht (2, 5, 13, 15, 17, 22, 23, 24) vor dem Verpressen einer Reinigung oder einer Oberflächenaktivierung wie z. B. einer Plasmabehandlung unterzogen wird.

18. Verfahren nach einem der Ansprüche 14 bis 17, wobei ein kalthärtender Klebstoff, ein thermoplastischer Heißschmelzkleber oder ein Duromer-Strukturkleber als Klebeschicht verwendet wird.

## Claims

1. An electromechanical transducer (1, 21, 28) having a layered structure comprising, in this order:
- a first layer (2) which has, in at least one plane, at least one outwardly insulated, structured, electrically conductive region (3) acting as an electrical shield,
- a second layer (6) serving as an adhesive layer, which is electrically conductive at least at certain points,
- a third layer (13, 22) comprising an electromechanical functional element,
- a fourth layer (15, 23) serving as an adhesive layer, which is electrically conductive at least at certain points,
- a fifth layer (17, 24) having in at least one plane at least one outwardly insulated, structured, electrically conductive region (18) acting as an electrical shield,
**characterized in that** the first layer (2) and/or the fifth layer (17, 24) has or have an electrical contact (8) exposed on its outer side (9, 25).

2. The electromechanical transducer according to claim 1, **characterized in that** the electrical contact (8) is designed as a plug or as a socket or as an electronic unit.

3. The electromechanical transducer according to one of the preceding claims, **characterized in that** each layer (2, 5, 13, 15, 17, 22, 23, 24) has at least one at least punctually electrically conductive contact (10, 11, 12) or a through-plating, via which or via which the layer (2, 5, 13, 15, 17, 22, 23, 24) is electrically conductively connected to an adjacent layer (2, 5, 13, 15, 17, 22, 23, 24).

4. The electromechanical transducer according to one of the preceding claims, **characterized in that** the second to fifth layers (6, 13, 15, 17, 22, 23, 24) have at least one electrically conductive connection to the first layer (2) directly or via a layer arranged therebetween.

5. The electromechanical transducer according to any one of the preceding claims, **characterized in that** two adjacent layers (2, 5, 13, 15, 17, 22, 23, 24), preferably all adjacent layers (2, 5, 13, 15, 17, 22, 23, 24), are bonded to each other in a material-to-material bond.

6. The electromechanical transducer according to claim 5, **characterized in that** at least two adjacent layers (2, 5, 13, 15, 17, 22, 23, 24), preferably all layers (2, 5, 13, 15, 17, 22, 23, 24), are connected to each other by a polymer matrix (5) in a material-locking and/or form-fitting manner.

7. The electromechanical transducer according to claim 5 or 6, **characterized in that** the material bond is formed on at least 20% of the surface of the electromechanical transducer (1, 21, 28) from polymers, in particular from a resin matrix.

8. The electromechanical transducer according to one of the preceding claims, **characterized in that** the functional element is designed as or comprises one of the following components: piezoelectric sensor (14), capacitive sensor, inductive sensor, conductivity sensor, resistive sensor, piezoresistive sensor, pyroelectric sensor, position sensor, gyrometer, Hall sensor, magnetometer, radar sensor, proximity sensor, or as electronic circuit.

9. The electromechanical transducer according to claim 8, **characterized in that** the electronic circuit comprises one or more of the following components: signal amplifier, filter, A/D converter, control unit for signal processing, data memory, wireless data transmission module, module for wireless transmission of power, ASIC (application specific integrated circuit), DSP (digital signal processor), FPGA (field programmable gate array).

10. The electromechanical transducer according to any one of the preceding claims, **characterized in that** at least one layer (2, 5, 13, 15, 17, 22, 23, 24) is thermally curable or cured or self-adhesive.

11. The electromechanical transducer according to any one of the preceding claims, **characterized in that** it comprises a plurality of layers comprising an electromechanical functional element.

12. The electromechanical transducer according to any one of the preceding claims, **characterized in that** at least one layer (2, 5, 13, 15, 17, 22, 23, 24) comprises a fiber-reinforced polymer.

13. The electromechanical transducer according to one of the preceding claims, **characterized in that** the adhesive layer is electrically insulating at least in sections and/or parallel to a plane defined by the adhesive layer.

14. Method of manufacturing an electromechanical transducer (1, 21, 28), comprising the following steps:
- Providing a first layer (2) which has, in at least one plane, at least one outwardly insulated, structured, electrically conductive region (3) acting as an electrical shield,
- provision of a second layer (6) serving as an adhesive layer, which is electrically conductive at least at certain points,
- providing a third layer (13, 22) comprising an electromechanical functional element,
- providing a fourth layer (15, 23) serving as an adhesive layer, which is electrically conductive at least at certain points,
- providing a fifth layer (17, 24) having in at least one plane at least one outwardly insulated, patterned, electrically conductive region acting as an electrical shield (18),
- stacking and aligning the first through fifth layers (2, 5, 13, 15, 17, 22, 23, 24) to form a panel,
- pressing the layers (2, 5, 13, 15, 17, 22, 23, 24) under pressure, and
- cutting the panel.

15. The method according to claim 14, wherein the layers (2, 5, 13, 15, 17, 22, 23, 24) are pressed together with the application of heat.

16. The method according to claim 14 or 15, wherein the layers (2, 5, 13, 15, 17, 22, 23, 24) are pressed together for a few minutes or a few seconds or preferably only for fractions of a second.

17. The method according to any one of claims 14 to 16, wherein at least one layer (2, 5, 13, 15, 17, 22, 23, 24) is subjected to cleaning or surface activation such as plasma treatment prior to pressing.

18. The method according to any one of claims 14 to 17, wherein a cold-curing adhesive, a thermoplastic hot-melt adhesive or a duromer structural adhesive is used as the adhesive layer.

## Revendications

1. Convertisseur électromécanique (1, 21, 28) avec une disposition de couches, comportant dans cet ordre :
- une première couche (2) qui présente dans au moins un plan au moins une zone (3) isolée vers l'extérieur, structurée, électriquement conductrice, agissant comme blindage électrique,
- une deuxième couche (6) servant de couche adhésive, qui au moins ponctuellement est électriquement conductrice,
- une troisième couche (13, 22) présentant un élément fonctionnel électromécanique,
- une quatrième couche (15, 23) servant de couche adhésive, qui au moins ponctuellement est électriquement conductrice,
- une cinquième couche (17, 24) qui présente dans au moins un plan au moins une zone (18) isolée vers l'extérieur, structurée, électriquement conductrice, agissant comme blindage électrique,
**caractérisé en ce que** la première couche (2) et/ou la cinquième couche (17, 24) comporte/comportent une connexion électrique (8) dégagée sur sa/leur face extérieure (9, 25).

2. Convertisseur électromécanique selon la revendication 1, **caractérisé en ce que** la connexion électrique (8) est réalisée sous forme de prise mâle ou de prise femelle ou sous forme de module électronique.

3. Convertisseur électromécanique selon l'une des revendications précédentes, **caractérisé en ce que** chaque couche (2, 5, 13, 15, 17, 22, 23, 24) comporte au moins un contact (10, 11, 12) tout au moins ponctuellement électriquement conducteur ou un trou métallisé, par le biais duquel contact ou duquel trou métallisé la couche (2, 5, 13, 15, 17, 22, 23, 24) est reliée de manière électriquement conductrice à une couche adjacente (2, 5, 13, 15, 17, 22, 23, 24).

4. Convertisseur électromécanique selon l'une des revendications précédentes, **caractérisé en ce que** la deuxième jusqu'à la cinquième couche (6, 13, 15, 17, 22, 23, 24) a au moins une liaison électriquement conductrice avec la première couche (2) directement ou par le biais d'une couche interposée.

5. Convertisseur électromécanique selon l'une des revendications précédentes, **caractérisé en ce que** deux couches adjacentes (2, 5, 13, 15, 17, 22, 23, 24), de préférence toutes les couches adjacentes (2, 5, 13, 15, 17, 22, 23, 24), sont reliées entre elles par liaison moléculaire.

6. Convertisseur électromécanique selon la revendication 5, **caractérisé en ce qu'**au moins deux couches adjacentes (2, 5, 13, 15, 17, 22, 23, 24), de préférence toutes les couches (2, 5, 13, 15, 17, 22, 23, 24), sont reliées entre elles par liaison moléculaire et/ou par complémentarité de forme par une matrice polymère.

7. Convertisseur électromécanique selon la revendication 5 ou 6, **caractérisé en ce que** la liaison moléculaire est réalisée en polymères, en particulier à partir d'une matrice de résine, sur au moins 20 % de la surface du convertisseur électromécanique (1, 21, 28).

8. Convertisseur électromécanique selon l'une des revendications précédentes, **caractérisé en ce que** l'élément fonctionnel est réalisé sous forme de l'un des composants suivants et/ou **en ce que** celui-ci comporte : un capteur piézoé-lectrique (14), un capteur capacitif, un capteur inductif, un capteur de conductivité, un capteur résistif, un capteur piézorésistif, un capteur pyroélectrique, un capteur de position, un gyromètre, un capteur à effet Hall, un magnétomètre, un capteur radar, un capteur de proximité, ou sous forme de circuit électronique.

9. Convertisseur électromécanique selon la revendication 8, **caractérisé en ce que** le circuit électronique comporte l'un ou plusieurs des composants suivants : amplificateur de signal, filtre, convertisseur A/N, dispositif de commande pour le traitement de signal, mémoire de données, module de transmission de données sans fil, module de transmission d'énergie sans fil, ASIC (circuit intégré spécifique), DSP (processeur de signal numérique), FPGA (matrice prédiffusée programmable).

10. Convertisseur électromécanique selon l'une des revendications précédentes, **caractérisé en ce qu'**au moins une couche (2, 5, 13, 15, 17, 22, 23, 24) est thermodurcissable ou est durcie ou autoadhésive.

11. Convertisseur électromécanique selon l'une des revendications précédentes, **caractérisé en ce qu'**il comporte plusieurs couches présentant un élément fonctionnel électromécanique.

12. Convertisseur électromécanique selon l'une des revendications précédentes, **caractérisé en ce qu'**au moins une couche (2, 5, 13, 15, 17, 22, 23, 24) comporte un polymère renforcé par des fibres.

13. Convertisseur électromécanique selon l'une des revendications précédentes, **caractérisé en ce que** la couche adhésive au moins sur certaines sections et/ou parallèlement à un plan défini par la couche adhésive est électriquement isolante.

14. Procédé de fabrication d'un convertisseur électromécanique (1, 21, 28) comprenant les étapes suivantes consistant à :
- préparer une première couche (2) qui présente dans au moins un plan au moins une zone (3) isolée vers l'extérieur, structurée, électriquement conductrice, agissant comme blindage électrique,
- préparer une deuxième couche (6) servant de couche adhésive, qui au moins ponctuellement est électriquement conductrice,
- préparer une troisième couche (13, 22) présentant un élément fonctionnel électromécanique,
- préparer une quatrième couche (15, 23) servant de couche adhésive, qui au moins ponctuellement est électriquement conductrice,
- préparer une cinquième couche (17, 24) qui présente au moins dans un plan au moins une zone (18) isolée vers l'extérieur, structurée, électriquement conductrice, agissant comme blindage électrique,
- superposer et aligner la première jusqu'à la cinquième couche (2, 5, 13, 15, 17, 22, 23, 24) pour former un flan,
- comprimer les couches (2, 5, 13, 15, 17, 22, 23, 24) sous pression, et
- découper le flan.

15. Procédé selon la revendication 14, en ce que les couches (2, 5, 13, 15, 17, 22, 23, 24) sont comprimées entre elles sous apport de chaleur.

16. Procédé selon la revendication 14 ou 15, en ce que les couches (2, 5, 13, 15, 17, 22, 23, 24) sont comprimées entre elles pendant quelques minutes ou quelques secondes ou de préférence uniquement pendant des fractions de secondes.

17. Procédé selon l'une des revendications 14 à 16, en ce qu'au moins une couche (2, 5, 13, 15, 17, 22, 23, 24) est soumise avant compression à un nettoyage ou à une activation de surface comme un traitement au plasma par exemple.

18. Procédé selon l'une des revendications 14 à 17, en ce qu'une colle séchant à froid, une colle thermofusible thermoplastique ou une colle structurale thermodurcissable est utilisée comme couche adhésive.
